Europäisches Patentamt

European Patent Office

Office européen des brevets

(11) Numéro de publication: **0 242 257**
**A2**

(12) **DEMANDE DE BREVET EUROPEEN**

(21) Numéro de dépôt: **87400647.1**

(22) Date de dépôt: **24.03.87**

(51) Int. Cl.⁴: **H 05 K 13/00,** H 05 K 13/04

(30) Priorité: **11.04.86 FR 8605188**

(43) Date de publication de la demande: **21.10.87**
**Bulletin 87/43**

(84) Etats contractants désignés: **AT BE CH DE FR GB IT LI LU NL SE**

(71) Demandeur: **Toniazzo épouse Tokarczyk, Joséphine, 15 Rue des Roses, F-92160 Antony (FR)**
Demandeur: **Remy, Jacques, 15 Rue des Roses, F-92160 Antony (FR)**

(72) Inventeur: **Toniazzo épouse Tokarczyk, Joséphine, 15 Rue des Roses, F-92160 Antony (FR)**
Inventeur: **Remy, Jacques, 15 Rue des Roses, F-92160 Antony (FR)**

(54) **Dispositif d'aide à l'insertion de composants électroniques.**

㊗ Dispositif d'aide à l'insertion de composants électroniques comportant un moyen de saisie numérique et de mémorisation de l'image du circuit imprimé à garnier (6) soit par caméra vidéo numérique ou par tout autre moyen équivalent via une interface, avec écran à mémoire et clavier (3), un moyen de chargement visuel de ladite image par ses composants électroniques à partir du modèle type et l'aide apportée consiste en un effet de transposition mentale qu'effectue l'opérateur entre la visualisation des informations numériques (7) vues sur l'écran et l'action d'insersion (10) proprement dite effectuée sur le circuit imprimé (6,1....).

0242257

## DISPOSITIF D'AIDE A L'INSERTION DE COMPOSANTS ELECTRONIQUES.

L'invention se rapporte au domaine des circuits imprimés et vise un dispositif d'assistance visuelle pour l'insertion des queues de composants électroniques dans leur trou correspondant avant soudage.

On sait que les opérations habituelles de ce genre d'assemblage consistent envers un opérateur:
- à lui présenter le circuit à garnir coté vu de dessus opposé à la face de soudage, .
- à mettre dans son champ de vision un modèle constitué par un schèma, un plan ou un circuit déja assemblé et dans son champ de préhension les composants nécessaires au garnissage du circuit.

Ces opérations étaient permises par une transposition mentale qu'effectuait l'opérateur depuis la localisation spatiale du composant vue sur le modèle jusqu'à l'insertion réelle dudit composant sur le circuit à garnir.

De telle opérations étaient fastidieuses et sources d'erreur par suite de l'attention intense que devait soutenir cet opérateur lors du garnissage d'un grand nombre de circuits imprimés disposés généralement côte à côte sur un plan horizontal.

Une amélioration au confort de l'opérateur a été apportée par les demandeurs à travers une console de type ergonomique faisant l'objet de leur demande de brevet EP N° 85401253.1 du 24.06.85. dans laquelle le plan de travail était réduit par le fait de plateaux mobiles verticalement de telle sorte que ledit opérateur pouvait rester posté en lui évitant ainsi tout déplacement fastidieux de va et vient entre le point de visualisation du modèle et les circuits à garnir.

0242257

Toutefois d'autre améliorations restaient à apporter notamment au niveau de l'aide à l'insertion des composants ce que propose maintenant la présente invention.

Dans l'invention,le dispositif proposé se présente sous la forme d'une unité ou système comportant essentiellement deux moyens ; l'un de saisie numérique et de mémorisation de l'image des circuits imprimés à garnir l'autre, de chargement visuel de l'image numérisée par les composants à insèrer; l'opérateur se trouvant aidé dans l'opération d'insertion par le fait des moyens informatisés mis en oeuvre.

Le dispositif proposé peut s'intégrer dans la console ergonomique sus-mentionnée pour constituer alors un ensemble totalement autonome. Il peut également être mis en oeuvre dans toute autre configuration isolée.

L'invention va être mieux comprise dans la suite du texte qui va donner à titre d'exemple et à l'appui des dessins annexés, une forme d'éxécution d'un dispositif ou système incluant les moyens informatisés conformes à cette invention.
Sur les dessins:

-La figure 1 est une vue en plan coté équipement,représentative d'un circuit imprimé nu en vue de sa saisie sous forme visuelle informatisée.

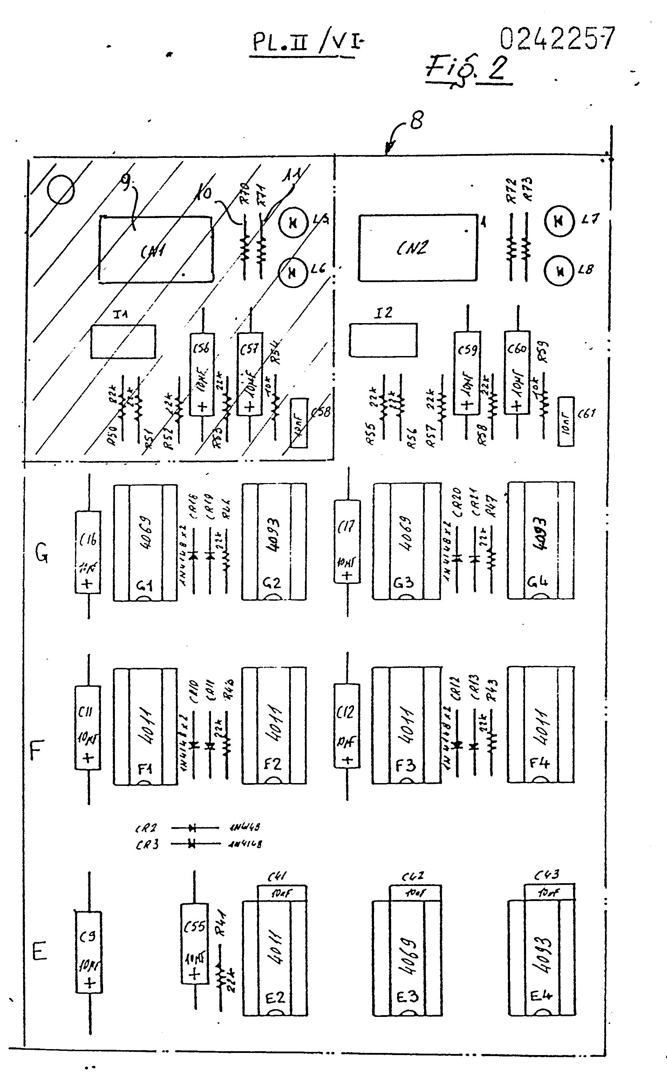

-La figure 2 est une vue partielle du plan d'équipement correspondant au circuit de la figure 1 et portant le repérage des composants.
-La figure 3 est une vue en perspective partielle montrant l'opération de saisie numérisée dudit circuit imprimé.
-La figure 4 est une vue en perspective partielle montrant après l'opération de saisie, l'opération de chargement à partir de la représentation des composants figurant sur le plan d'équipement.
- La figure 5 est une vue schématique partielle montrant une partie de l'image saisie et en cours de chargement correspondant à la partie hachurée de la Fig.2 (Agrand. de la Fig.4)
-Les figures 6a et 6b sont des représentations symboliques des composants soit à trajectoriser, soit à positionner et à orienter sur recherche en bibliothéque.

-La figure 7 est une vue en perspective partielle montrant l'opération d'insertion proprement dite au vu de l'image saisie et chargée.

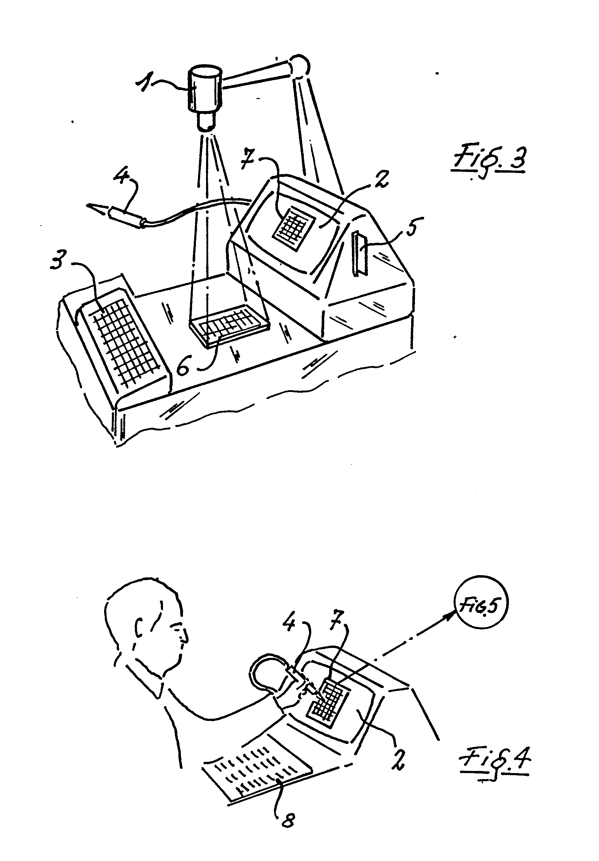

Lors de l'opération de saisie, le dispositif conforme à l'invention comporte en premier lieu comme cela ressort de l'examen de la figure 3,des moyens connus de saisie comprenant essentiellement par exemple, une caméra vidéo numérique rep.1 via une interface, un moniteur rep.2 à mémoire et son calculateur un clavier rep. 3, un outil de saisie interactif tel qu'un crayon opt. rep. 4 et un lecteur genre disquette rep. 5.

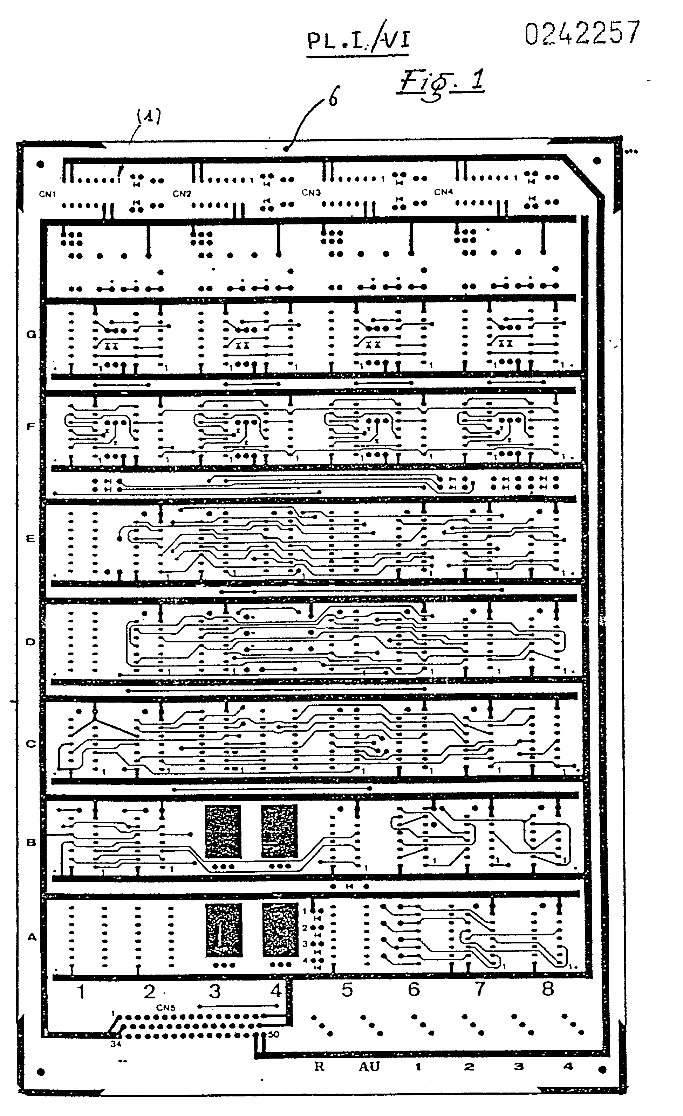

Le circuit imprimé nu rep. 6 tel que représenté par exemple sur la figure 1, est mis en mémoire à partir de la caméra 1 sous la forme d'une image numérisée apparaissant en 7 sur l'écran de contrôle rep. 2.

L'image numérisée peut également être saisie à partir d'un scanner où d'une imprimante avec lecteur optique comme cela est bien connu dans la pratique des systèmes de saisie numérique.

Le clavier 3 permet d'entrer en mémoire et de visualiser toute information complémentaire utile propre au circuit considéré( N° d'ordre, titre du circuit, etc...)

L'opération de saisie est terminée à ce stade et le support informatique tel que la disquette rep. 5, peut dès lors être disponible pour l'opération suivante de chargement des composants.

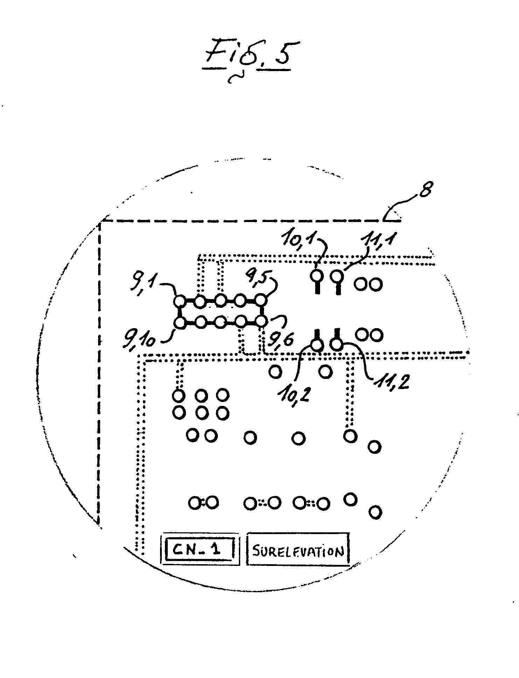

Cette deuxième opération s'effectue d'une part, à l'aide de la nomenclature des composants telle que repérée 8 sur le schéma papier représenté par exemple selon la figure 4 et d'autre part, à l'aide de l'outil interactif qui peut être le crayon rep. 4. Il pourrait également s'agir d'une bibliothèque ayant pré-enregistré les symboles des composants.

Dans le premier cas avec les symboles tracés, l'opérateur fait apparaître sur l'écran en usant éventuellement d'un effet de loupe tel que cela est montré sur la figure 5, une partie de l'image du circuit 6 à traiter puis, à l'aide de son outil 4 effectue le trajet jointif de tous les trous (9,1→9,5→9,6→9,10→9,↵ pour le composant 9) représentatif du composant à positionner en affichant corrélativement à l'aide du clavier 3, le repére dudit composant (CN.1 dans l'exemple).Le repére s'affiche dans une fenêtre complété de commentaires éventuels(Ex."surélévation"),

La trace de ce positionnement sera par exemple représentée par un trait gras.

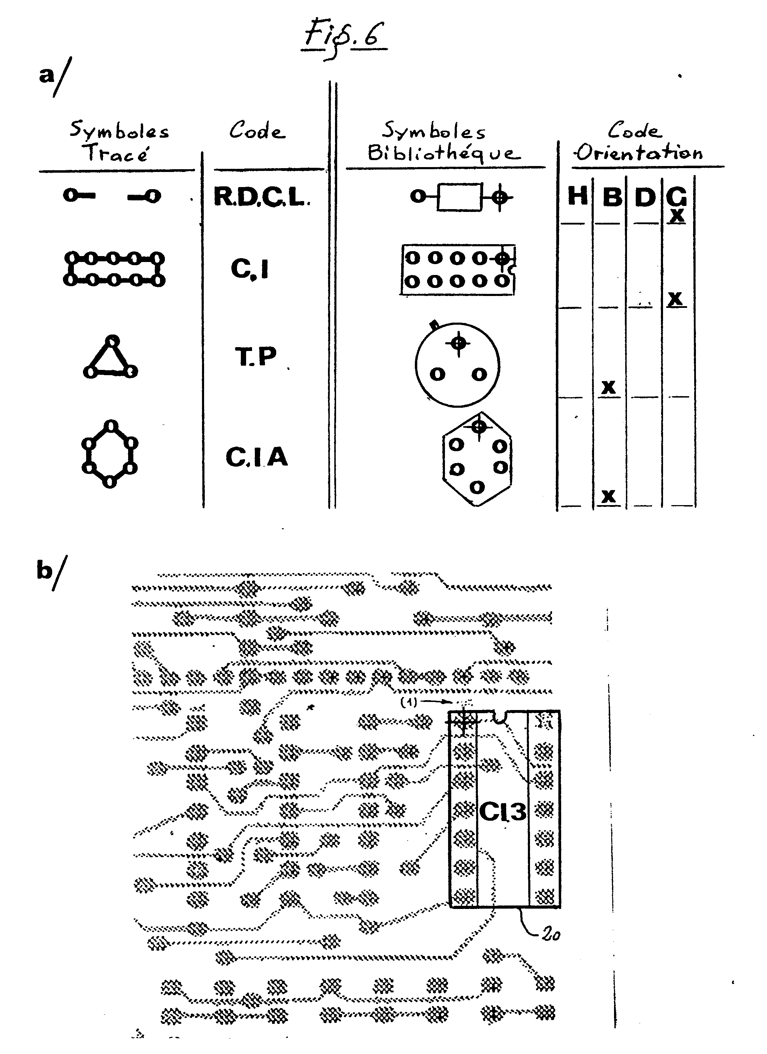

Une résistance ou un condensateur ou tout autre composant n'ayant que deux trous seront matérialisés par un court trajet représentatif de la direction de son positionnement tel que 10,1→10,2 (R70) pour le composant 10 et 11,1→11,2 (R71) pour le composant 11 dans l'exemple. La figure 6 montre les cas les plus courants de représentations codées des principaux composants: R résistance, D diode, C condensateur, L self, CI circuit intégré, etc...

Un tel mode de chargement de symboles tracés peut présenter des difficultés pour l'orientation de certains composants polarisés tel un condensateur par exemple.

Afin de palier cette difficulté, un autre mode de chargement équivalent peut être utilisé à l'aide d'une bibliothèque de symboles pré-enregistrés comme cela est montré sur la partie droite de la figure 6a.

La polarisation du composant est indiquée sur son image symbolisée par un repère précis, une croix par exemple, que l'opérateur vient loger en surimpression sur l'image du trou correspondant du circuit qui est lui-même repéré.Bien entendu tout autre signe distinctif qu'une croix pourrait tout aussi bien convenir.

Le repére du trou du circuit est conventionnel: ce sera un 1 par exemple pour un circuit intégré.

L'orientation du composant complète ce positionnement à l'aide d'un code de sens d'orientation classique tel que:
H→haut, B→bas, D→droite, G→gauche, HD→haut/droite etc...

La figure 6b montre ainsi comment,à partir d'une image de circuit imprimé saisie par un scanner,(sortie en papier sur imprimante à aiguilles sur cette figure), il est possible de positionner et orienter un composant donné sur un circuit imprimé donné en centrant la croix dudit composant sur le trou de circuit repéré 1 puis en l'orientant à partir du code orientation par rapport à la position des trous d'enfichage (code B dans l'exemple). Le repére du composant est corrélativement mentionné tel que C I.3 dans l'exemple.

Le chargement terminé de tous les composants prépare la phase ultérieure d'insertion proprement dite desdits composants.

En effet et dès que tous les composants sont ainsi chargés sur l'image numérique saisie du circuit imprimé, le support informatique tel que la disquette rep.5 est dès lors disponible pour l'insertion des composants comme cela va être exposé maintenant.

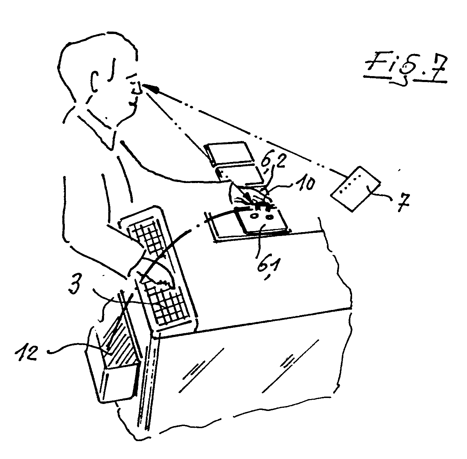

La phase d'insertion des composants commence par leur préparation et leur sélection tandis que la préhension manuelle peut s'effectuer à partir d'un site prévu à cet effet qui peut être un sachet ou un tiroir tel que celui repéré 12 sur la Figure 7.

L'opérateur fait apparaître sur l'écran l'image 7 du circuit imprimé intéréssé chargée (6 dans l'exemple) et appelle par le clavier 3 le repére du composant qu'il souhaite insérer. (10 dans l'exemple).

Ainsi,la saisie de la trace de la trajectorisation jointive d'un composant sélecté ou la saisie de la symbolisation préenregistrée permet:
   1° l'appel par l'opérateur d'un premier composant donné déclenchant le clignotement ou l'animation du symbole dudit composant sur son lieu d'insertion,

2° l'appeld'un deuxième composant donné déclenchant le clignotement ou l'animation du symbole dudit composant sur son lieu d'insertion; l'image du symbole du premier composant se fixant définitivement sur l'écran et ainsi de suite pour le troisième et les autres composants.

L'opérateut affiche sur le clavier rep.3 le repére du composant suivant qu'il a choisi à son gré, ce qui a pour effet de figer en trait gras par exemple sur l'image,le composant précédant et d'animer le composant demandé et ainsi de suite pour tous les composants des circuits imprimés (6,1 - 6,2 ...)

L'appel d'un composant donné par le clavier rep.3 peut permettre comme çela est montré sur la figure 7 de déverrouiller un tiroir (12 dans l'exemple) qui ne contient que les seuls composants d'une même espèce à insérer (10 dans l'exemple) en rendant ainsi toute erreur impossible. Un autre moyen tout aussi efficace consiste à identifier des sachets à l'aide d'une lecture code/barres par exemple et à n'ouvrir ces sachets qu'après que l'identification  des composants n'ait été répercutée sur l'écran.

Le dispositif décrit convient tout particuliètrement à la console ergonomique dont il a été fait état au début de l'exposé et ce, en raison des possibilités d'intégration offertes et qui s'interprètent aisèment à l'aide des figures 3 et 7.

On peut également intégrer le dispositif selon l'invention sur tout autre système en particulier sur une chaîne de fabrication auquel cas, ledit dispositif devient alors totalement autonome.

Les moyens informatiques de visualisation mis en oeuvre peuvent être mis à profit pour produire l'affichage de nombreuses informations. En particulier et à partir d'une horloge intégrée, le temps de fabrication d'un circuit peut être déterminé en vue d'une évaluation de prix par exemple.

Il peut de même être fait usage de couleurs différentes pour visualiser tous les composants d'une même espèce et en général, toutes les possibilités offertes notamment par le langage informatique intéractif (crayon optique,souris...) peuvent être mises à profit dans l'invention.

Il est évident que le cas d'insertion de composants électroniques ci-dessus mentionné n'a été donné qu'à titre d'exemple pour bien montrer comment l'invention peut être appliquée et que dans cet esprit,ladite invention pourrait être étendue à tous les processus d'assemblages analogues touchant tous les domaines : mécanique,électrique, etc....

L'invention qui peut être mise à profit dans tous les secteurs,est caractérisée dans les revendications qui suivent.

## REVENDICATIONS

1 - Dispositif d'aide à l'insertion de composants électroniques caractérisé en ce qu'il comporte:
- un moyen de saisie numérique et de mémorisation de l'image du circuit imprimé à garnir,
- un moyen de chargement visuel de ladite image par ses composants électroniques et ce.à partir du modèle type, lesdits moyens étant tels que l'opération d'insertion est aidée par un effet de transposition mentale qu'effectue l'opérateur entre la visualisation des informations numériques mémorisées et l'action d'insertion proprement dite desdits composants.

2 - Dispositif d'aide à l'insertion de composants électroniques selon la revendication 1 caractérisé en ce que le moyen de saisie comporte une caméra vidéo numérique (1) via une interface, un écran ou moniteur (2) à mémoire, un clavier (3), un outil de saisie interactif (4) et un lecteur (5); ladite caméra pouvant être remplacée par tout autre moyen de saisie à digitalisation équivalent connu tel qu'un numériseur à imprimante ou un scanner.

3 - Dispositif d'aide à l'insertion de composants électroniques selon la revendication 1 caractérisé en ce que le moyen de chargement comporte un modèle type (8), une image numérisée (7) du circuit imprimé (6), une trajectorisation jointive par l'outil interactif des trous (9,1→9,5→9,6→9,10→9,1) représentatifs du composant à positionner (9...), un repérage de chaque composant (CN1...) ; chaque composant pouvant en variante être positionné orienté et repéré à partir d'une bibliohhèque de symboles pré-enregistrés (CI.3..) avec explications complémentaires

4 - Dispositif d'aide à l'insertion de composants électroniques selon la revendication 3 caractérisé en ce que le modèle type (8) est un schéma, un plan d'équipement ou une maquette.

5 - Dispositif d'aide à l'insertion de composants électroniques selon l'une des revendications 1 ou 3 caractérisé en ce que

: la saisie de la trace de la trajectorisation jointive d'un composant sélecté ou la saisie de sa symbolisation préenregistrée permet:

1° l'appel par l'opérateur d'un premier composant donné qui déclenche le clignotement ou l'animation du symbole dudit composant sur son lieu d'insertion,

2° l'appel d'un deuxième composant donné déclenchant le clignotement ou l'animation du symbole dudit composant sur son lieu d'insertion; l'image du symbole du premier composant se fixant définitivement sur l'écran et ainsi de suite pour le troisième et les autres composants de tous les circuits à garnir (6,1-6,2.)

6 - Dispositif d'aide à l'insertion de composants électroniques selon la revendication 5 caractérisé en ce que l'appel opérateur d'un composant donné produit, soit le déverrouillage d'un tiroir (12) correspondant contenant tous les composants d'une même espèce. soit permet l'identification avant ouverture d'un sachet de composants donnés par lecture d'un code/barres imprimé sur ledit sachet.

7 - Dispositif d'aide à l'insertion de composants électroniques selon l'une quelconque des revendications 1 à 6 caractérisé en ce qu'il peut être intégré sur une console ergonomique du type à plateaux mobiles verticalement.

PL.I/VI   0242257

Fig. 1

## Fig. 2

_Fig.3_

_Fig.4_

_Fig. 5_

## Fig.6

**a/**

| Symboles Tracé | Code | Symboles Bibliothéque | Code Orientation | | | |
|---|---|---|---|---|---|---|
| | | | H | B | D | C |
| o—  —o | R.D.C.L. | o—▭—⊕ | | | | X |
| (chaîne) | C.I | (boîtier) | | | | X |
| △ | T.P | (cercle) | | X | | |
| ⬡ | C.I.A | (hexagone) | | X | | |

**b/**

(1) →

Cl3

20

Fig.7